# EUROPEAN PATENT SPECIFICATION

(11) **EP 0 342 175 B1**
(45) Date of publication and mention of the grant of the patent: **20.03.1996**
(21) Application number: 89850149.9
(22) Date of filing: 09.05.1989
(51) Int. Cl.: H01Q 9/04, H01Q 25/00, H01Q 21/06

(54) **Dual-polarized printed circuit antenna having its elements, including gridded printed circuit elements, capacitively coupled to feedlines**
Dualpolarisierte, in gedruckter Schaltungstechnik ausgeführte Antenne, deren Elemente, mit gedruckten Gitterschaltungselementen darin einbegriffen, mit den Speiseleitungen kapazitiv gekoppelt sind
Antenne circuit imprimé à double polarisation dont les éléments, incluant des éléments circuit imprimé en grille, sont couplés capacitivement aux lignes d'alimentation

(30) Priority: 10.05.1988 US 192100
(43) Date of publication of application: 15.11.1989
(73) Proprietor: COMSAT Corporation, Bethesda, MD 20817 (US)
(72) Inventor: Zaghloul,Amir Ibrahim, Bethesda, Maryland 20817 (US); Sorbello,Robert Michael, Potomac, Maryland 20854 (US)
(74) Representative: Axelsson, Rolf

(56) References cited:
- FR-A- 2 603 744
- GB-A- 2 194 101
- US-A- 4 403 221
- US-A- 4 450 449
- ELECTRONICS LETTERS. vol. 22, no. 20, 25 September 1986, ENAGE GB pages 1040 - 1042; James and Andrasic: "DICHROIC DUAL-BAND MICROSTRIP ARRAY"

## Description

### BACKGROUND OF THE INVENTION

The present invention relates to a dual-polarized printed circuit antenna having feedlines and radiating elements stacked one above the other with feedlines which are capacitively coupled to the radiating elements, such that no RF interconnection is required. By employing electromagnetic coupling in the power transfer from the distribution networks to the radiating elements, a high-performance, light weight, compact, low-cost dual polarized planar or conformal antenna is achieved.

According to another aspect of the invention, the radiating elements used are gridded elements formed by selective removal of metallization. With such structure, superior performance is achieved.

Examples of previous work in the field of printed circuit antennas employing capacitive coupling are found in commonly-assigned U.S. Patent No. 4,761,654 which corresponds to EP-A-0 270 029, and also in U.S. Patent Application Ser. No. 930,187 which corresponds to EP-A-0 271 458, filed November 13, 1986. The patent and the application disclose printed circuit antennas employing capacitive coupling and enabling either linear or circular polarization, depending on the shape of the radiating and feeding elements (which may be patches or slots) which are used.

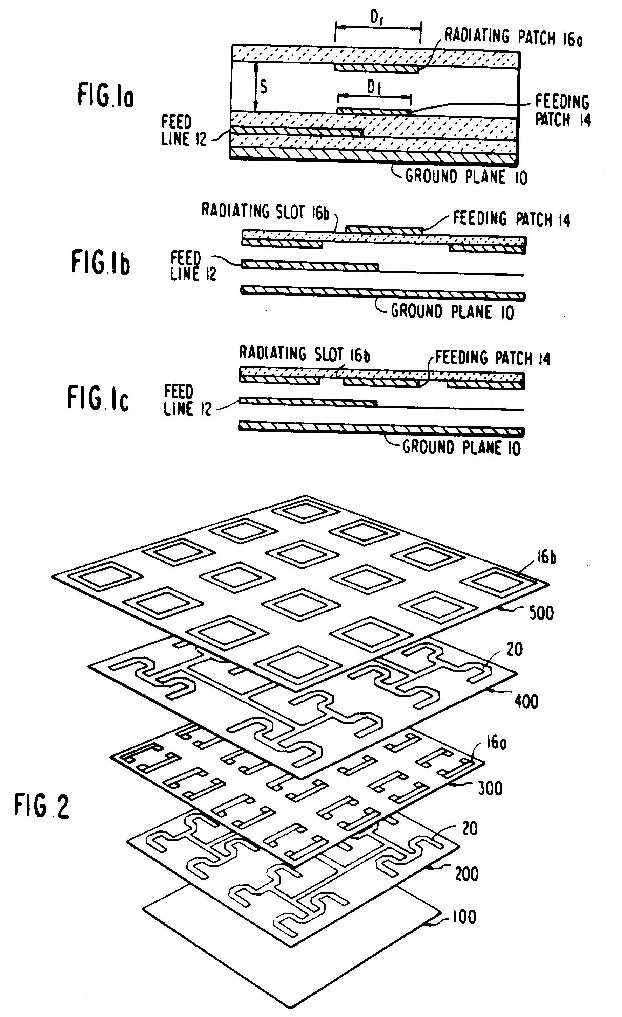

As shown in Fig. 1a, the ground plane 10, feedline 12, and feeding patch 14 are capacitively coupled. Alternative structures, employing radiating slots 16b, are shown in Figs. 1b and 1c as well. The resulting structure is a light weight, low-cost, singly-polarized planar or conformal antenna capable of operating with either linear or circular polarization.

One limitation of this structure is that the antenna constructed according to the techniques disclosed in these co-pending applications can receive only one sense of polarization, either linear or circular, from a satellite. It is desirable to have a compact antenna structure which is capable of receiving both senses of polarization, so that twice as much information can be received.

One technique for achieving this desired result involves the provision of a dual-polarized antenna structure. However, because of problems inherent in the interaction among the various radiating elements and the power dividers in different layers in such a structure, it has not previously been possible to provide such an antenna. This problem is solved by the present invention.

Also, previously-known configurations for radiating elements have employed either a patch or slot geometry, wherein circular or rectangular patches or slots, with or without perturbation segments provided thereon, may be provided. While the antennas as disclosed in the three above-mentioned applications have yielded good results over a relatively large bandwidth, the present inventors have discovered that it is possible to provide yet futher improvement in performance.

With the dual-polarized antenna structure solution as disclosed and claimed herein, the inventors also have discovered a high aperture efficiency, high polarization purity antenna element which is transparent to orthogonally polarized radiation. This last aspect of the invention is applicable to printed circuit antennas employing single-polarization and dual-polarization geometries.

The French patent No. 2 603 744, which has an English language equivalent as U.S. Patent 4,816,835, discloses a dual polarization technique in which only a single layer of radiating elements is provided, with two orthogonally-positioned arrays of power supplying circuits being used to provide the two senses of polarization.

The article "Dichroic Dual-Band Microstrip Array", Electronics Letters, Vol. 22, No. 20, September 25, 1986, pp, 1040-1042, also discloses the concept of a dual-band microstrip array, with feeders in the same plane as the radiating elements.

US-A-4,403,221 discloses a microstrip antenna with orthogonally-positioned inputs to a single element, to provide two senses of polarization.

### SUMMARY OF THE INVENTION

In view of the foregoing deficiencies, it is one object of the present invention to provide a dual-polarized printed circuit antenna which has its elements capacitively coupled to feedlines, and which minimizes cross-coupling between the arrays.

It is a further object of the present invention to provide a printed circuit antenna which is capable of receiving both senses of polarization.

It is a yet further object of the present invention to provide a dual-polarized antenna which does not require a direct probe to each radiating element for any of the senses of polarization provided in the antenna.

It is a still further object of the present invention to provide a dual-polarized printed circuit antenna which uses capacitive coupling from each power divider (corresponding to each polarization) to a respective radiating element.

It is a further object of the present invention to provide a radiating element for use in printed circuit antennas employing either single or dual polarization geometries, yielding improved performance over a wide bandwidth.

In view of these and other objects, the present invention provides a dual-polarized printed antenna according to claim 1. The power dividers may be disposed orthogonally with respect to each other, such that the antenna can recieve two signals with opposite senses of polarization. The shape of the radiating elements may be such as to enable either linear or circular polarization to be achieved for each sense of polarization. Alternatively, a quadrature hybrid or other directional coupler may be employed with a dual polarized linear array to provide an equal power split and 90° phase between the two respective ports to develop a dual circularly polarized array.

The construction format of the present invention yields much lower dissipative loss than has been observed previously in most conventional flat planar arrays which incorporate a transmission medium such as microstrip.

In accordance with the last-mentioned object of the invention, an embodiment of the inventive radiating element is formed based on a gridded structure which is transparent to one polarization while acting as a solid conducting plane to the other polarization. One form of this structure also makes the field distribution more uniform across the aperture. As a result, there is higher gain and a higher degree of isolation between the two orthogonal polarizations.

### BRIEF DESCRIPTION OF THE DRAWINGS

The present invention now will be described with reference to the accompanying drawings, in which:
Figs. 1a-1c show cross-sections of structure for a known single-polarized antenna disclosed in the above-mentioned co-pending applications;
Fig. 2 shows a blown-up view of the dual-polarization geometry in the printed circuit antenna of the present invention;
Figs. 3a-3l show examples of shapes of radiating elements which may be used in the antenna of Fig. 2 to achieve linear polarization;
Figs. 4a-4f show examples of shapes of radiating elements which may be used in the array of the antenna of Fig. 2 to achieve circular polarization;
figs. 5a-5d show examples of gridded structures in accordance with the present invention;
Figs. 6a and 6b show examples of ungridded structures for array elements;
Figs. 7a-7c show alternative structures for the feedline which feeds the radiating elements of the array of the antenna of Fig. 2;
Fig. 8 shows a dual polarization geometry similar to Fig. 2, but with the elements of Figs. 5a and 5b;
Fig. 9 shows a view of a quadrature hybrid which may be used in conjunction with the inventive antenna to provide dual circular polarization with a dual-polarized linear array;
Figs. 10-15 show examples of the results achieved with the dual-polarization implementation of the present invention; and
Figs. 16-18 show the gain, polarization isolation, and port-to-port isolation of a 16-element array using the structure shown in Fig. 8.

### DETAILED DESCRIPTION OF A PREFERRED EMBODIMENT

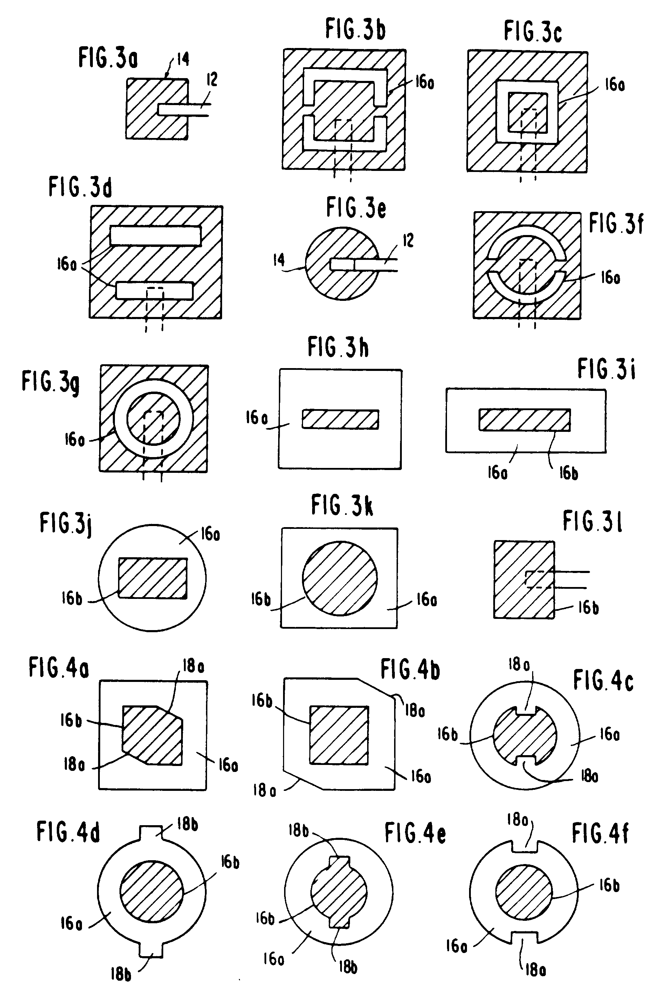

Fig. 2 is a blown-up depiction of an example of the dual-polarization geometry of the antenna of the present invention. Shown in the figure are ground plane 100, a first power divider 200 having power divider elements 20, a first sheet of radiating elements 300, a second power divider 400 having power divider elements 20 which may be disposed orthogonally to the power divider elements in the first power divider 200, and a second sheet of radiating elements 500. The radiating elements on the sheets 300 and 500 may comprise patches or slots. Examples of suitably-shaped radiating elements are shown in Figs. 3a-3l and 4a-4f. Further, according to a particular feature of the invention, the radiating elements preferably comprise gridded elements, as shown in Figs. 5a-5d, as will be discussed herein.

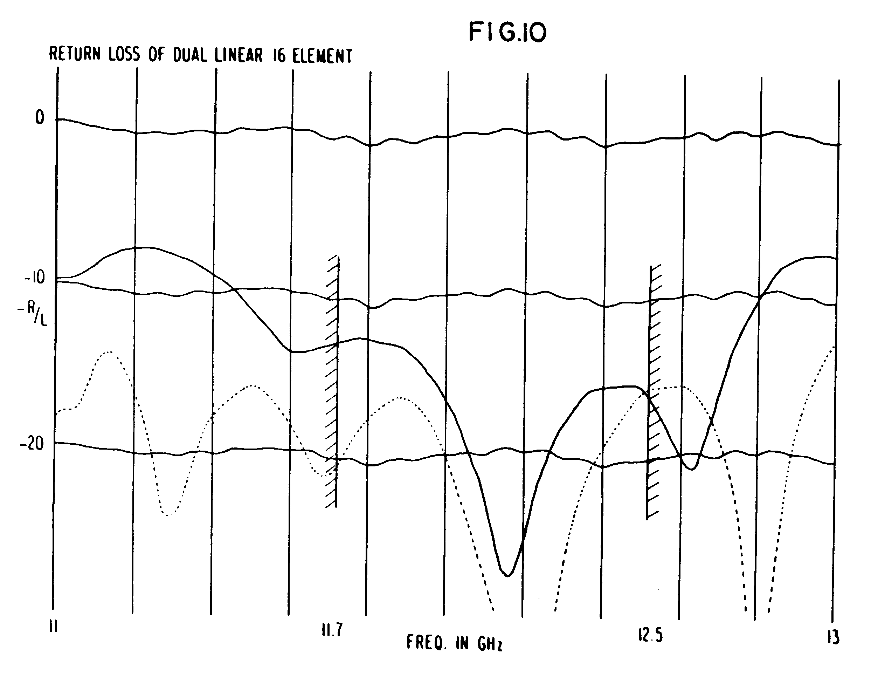

The elements shown in the antenna of Fig. 2 are linear elements. These also may be used in a circularly-polarized array by means of a quadrature hybrid 250, which is shown in Fig. 9. Alternatively, the elements may be intrinsically circularly polarized and configured as shown in Fig. 4a-4f, wherein notches 18a or tabs 18b are provided on the elements.

In construction, the layers shown in Fig. 2 are appropriately spaced and stacked one over the other with no interconnects between the radiating elements. Spacing is in accordance with the wavelength of electromagnetic radiation λ which is being received. One such spacing may be, for example, λ/10; other spacings may be provided as appropriate, but of course would require different optimization of the elements in the various layers, as is known to those working in the relevant art.

All feeding to all the elements in the array of Fig. 2 is done by capacitive coupling. Essentially two arrays are formed. A first array having a first sense of polarization is formed by ground plane 100, power divider 200, and element board 300. In this array, the layers 100 and 300 form the ground plane for the power dividers, and layer 300 also contains the printed radiating elements.

A second sense of polarization is formed by layers 300, 400 and 500, wherein the layers 300 and 500 provide the ground plane for the power divider 400, and layer 500 contains the printed radiating elements.

The element designs on layers 300 and 500 are selected appropriately to minimize both radiation interaction between the lower and upper arrays, and cross-talk between the two power distribution networks. It should be pointed out that there tends to be a natural interaction between the networks in layers 200 and 400, shown in Fig. 2. The metal portion of the layer 300 thus acts as isolation to prevent the two networks from "talking to each other", a phenomenon known as cross-talk. It is important to minimize cross-talk in order to maximize the independence of operation of the arrays.

To improve this isolation, the elements in the layer 300 may differ slightly from the elements in the layer 500. More specifically, additional metallization is provided along a line in each of the elements in the layer 300, so that the radiating slots 16a which are shown in the layer 300 essentially comprise two U-shaped slots. In the limit, the radiating slots may comprise two parallel slots, as shown in Fig. 3d.

Another consideration is that the size of the inner portion of the slots 16b in the elements of layer 500 affects how much energy is blocked to the bottom array. If the layer 500 has shapes that are too big, the first array comprising layers 100, 200 and 300 may not be able to "see through" the layers 400 and 500, so that those layers would not be transparent with respect to energy transmitted to that bottom array.

More specifically with respect to the particular construction of the elements in the layer 500, the squares in the slot 16b are similar to what is disclosed in copending application Serial No. 930,187. The layer 300 also may have shapes similar to that in application Serial No. 930,187, but as mentioned above, there is a little additional metallization as shown to form two U-shaped shapes out of the square.

Basically, the elements in the sheet 300 are essentially the same as those in the sheet 500 to start with. However, the lines in the power divider sheet 400 need metal underneath where those lines go underneath the elements in the sheet 500. Accordingly, part of the slot or layer in the elements 300 is covered up with metal, resulting in the two U-shaped pieces shown in Fig. 2. The dual-polarization geometry of the present invention enables the two arrays to operate substantially independently of each other.

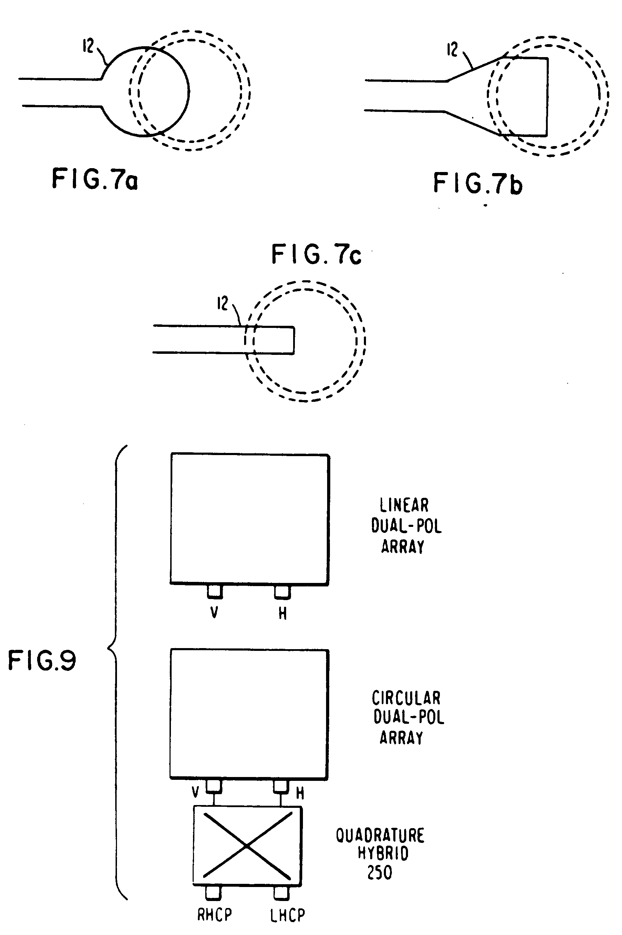

The feedlines 12 which feed the radiating elements in the sheets 300 and 500 may have any suitable shape. For example, as shown in Figs. 7a-7c, the end of the feedline 12 which is capacitively coupled to a respective radiating element may be paddle shaped (Fig. 7a); wider at one end than at the other (Fig. 7b); or simply straight (Fig. 7c).

All the layers shown in Fig. 2 are separated by a suitable dielectric. Air presently is preferred as a dielectric, with a suitable honeycomb structure being provided among the layers to provide physical separation, as is well known to those of working skill. Polyethylene, Duroid(tm), nomex, or Teflon(tm) also may be used. However, it should be noted that, depending on the dielectric used, efficiency of the antenna could be degraded, as dielectrics tend to be lossy at microwave frequencies.

The operation of the dual-polarized array shown in Fig. 2 is as follows. As mentioned above, what is shown is dual linear polarization, which is dictated by the radiating elements. The two arrays of elements are fed orthogonally, such that one array will radiate either vertical or horizontal polarization, and the other array will radiate correspondingly horizontal or vertical polarization. One way of obtaining circular polarization was described above, with reference to Figs. 4a-4f. However, as shown in Fig. 9, it may be possible to achieve dual circular polarization by having a quadrature hybrid at the input of the array. A quadrature hybrid 250, as shown in Fig. 9, is essentially a directional coupler which is well-known in the art, and need not be described in detail here. However, it should be noted that the quadrature hybrid is connected to the arrays such that the two output ports of the hybrid feed the vertical and horizontal ports of the array, respectively. The input ports of the hybrid then would correspond to right-hand and left-hand polarization, respectively. Such a quadrature hybrid provides inherent isolation so as to allow both senses of polarization to operate simultaneously. The hybrid 250 may be implemented as an external component, or may be integrated directly into the array.

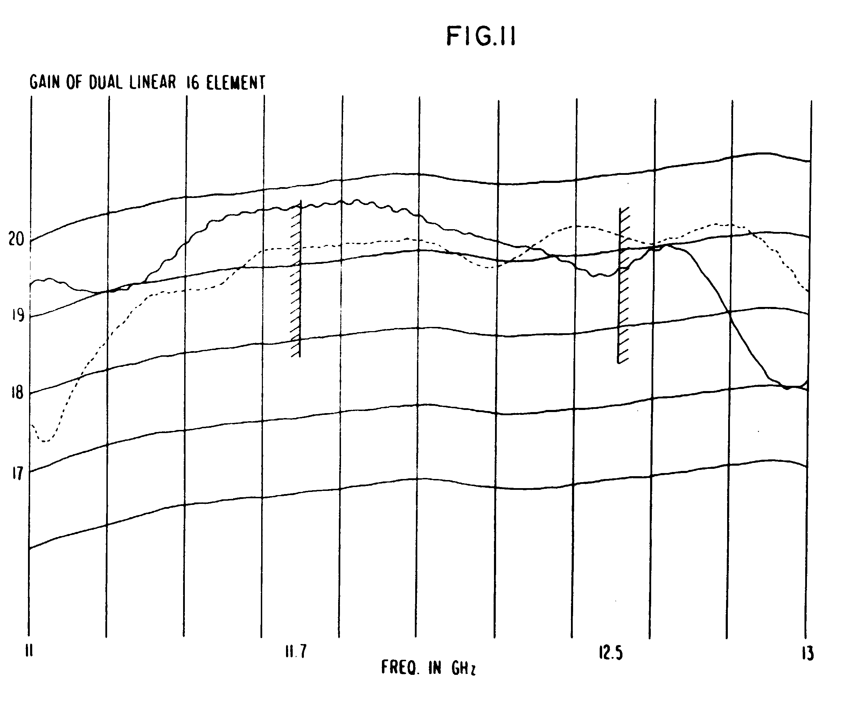

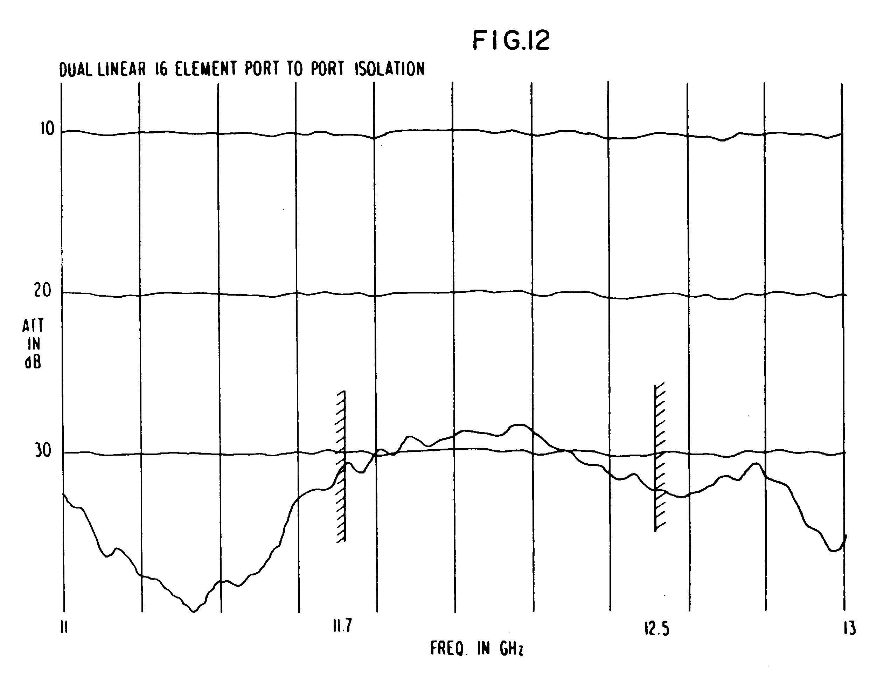

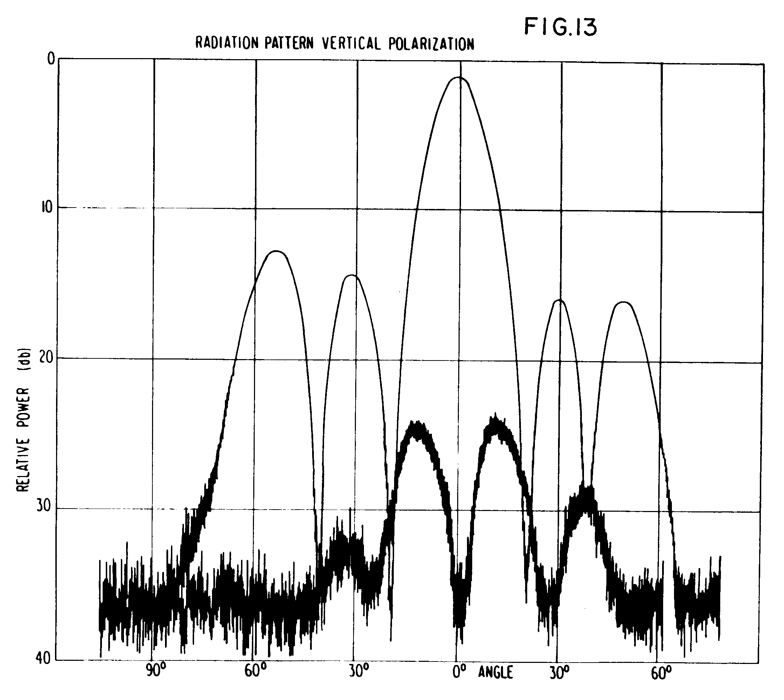

Figs. 10-14 show results achieved with an example of the inventive dual polarized linear array employing 16 elements. Fig. 13 shows the input return loss for both senses of polarization. It should be noted that the figure shows very good input match over a broad band.

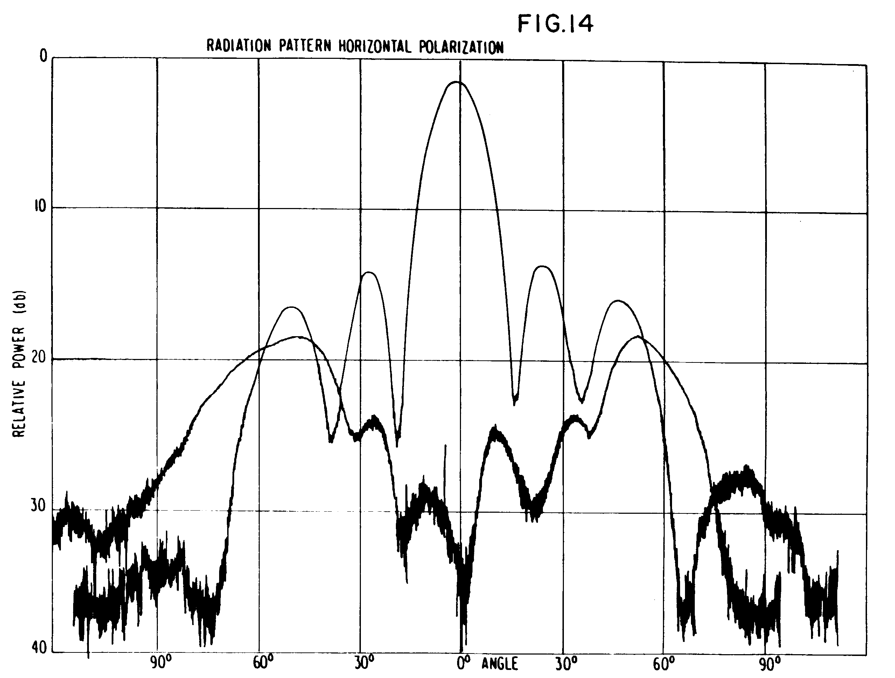

Fig. 14 shows the corresponding radiation gain for each polarization, and shows very efficient radiation over a broad band for both senses of polarization. The radiation efficiency of each of the arrays appears comparable.

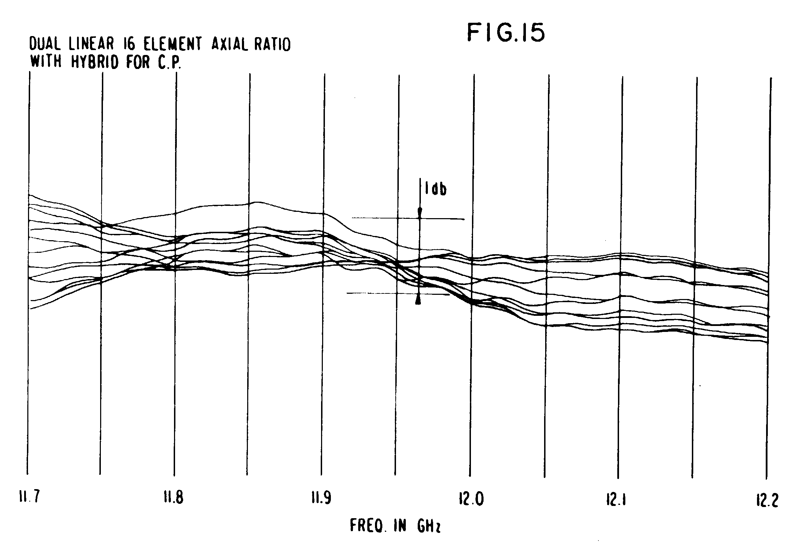

Fig. 15 shows array network isolation. The two arrays are virtually decoupled, and operate as required in an independent manner, as shown in this graph.

Figs. 13 and 14 show corresponding radiation patterns for each sense of polarization. The figures demonstrate the efficiency of the radiating array, and the low radiated cross-polarization.

Fig. 15 shows an example of the mapping of the dual-polarization linear to dual-polarization circular by a quadrature hybrid. To achieve the results shown in this figure, the 16 element array which was the subject of the experiment was converted to circular polarization by placing an external quadrature hybrid on the vertical and horizontal ports of the array. Fig. 15 shows the resultant measured axial ratio, and demonstrates that good circular polarized performance can be achieved over a large bandwidth.

It should be understood that although the data shown in Figs. 10-15 was achieved for a specific frequency band, the invention is not so limited. Rather, what has been described is a dual-polarized antenna design that can be implemented at any frequency and for any size array, or for any number of elements. Thus, it should be understood that the invention is not to be limited by the description of the foregoing embodiment.

As will be described in greater detail below, the arrays of gridded radiating elements of the present invention may be achieved by removing additional metal from the metallization layer from which the individual radiating slots are formed. Alternatively, some metal may be left in the slots selectively, so as to provide a gridded structure within the slots themselves.

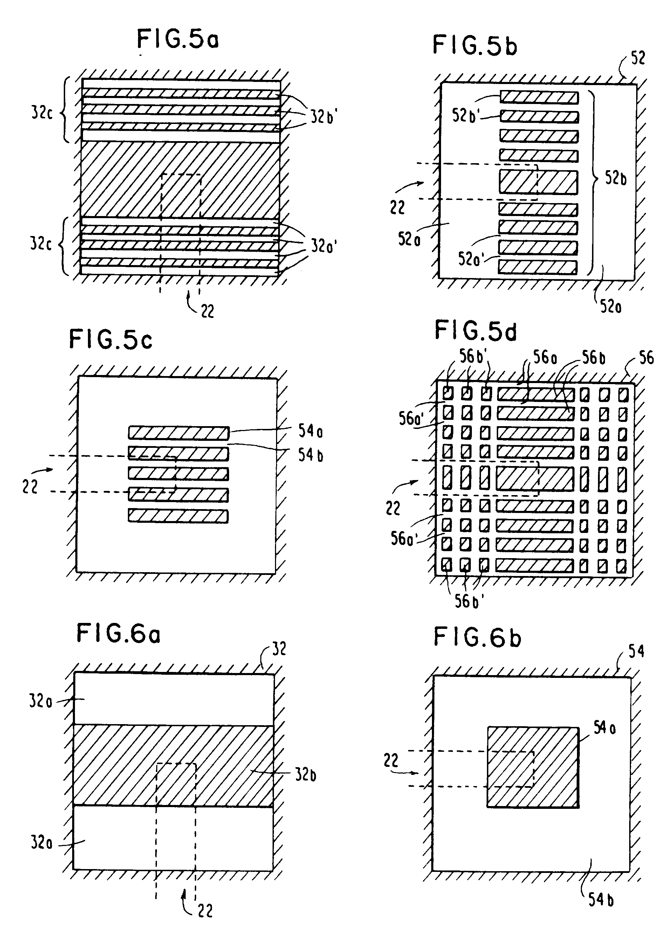

As shown in Figure 6a, an ungridded radiating element 32 comprises a pair of parallel slots 32a surrounding a single interior metallization region 32b. Such an element has a cosine distribution function for the aperture electric field, having a maximum at the slot center and tapering to zero at the edges.

Figure 5a differs from Figure 5a in that two gridded regions 32c are provided. To form this structure, when the metallization is removed to form slots, the removal is more selective, so that thin metallization areas remain. By providing such structure, each wide slot 32a effectively is divided into an array of narrow slots 32a′ with thin metal regions 32b′. The array of narrow slots has a more uniform distribution across the aperture, so as to increase the element gain.

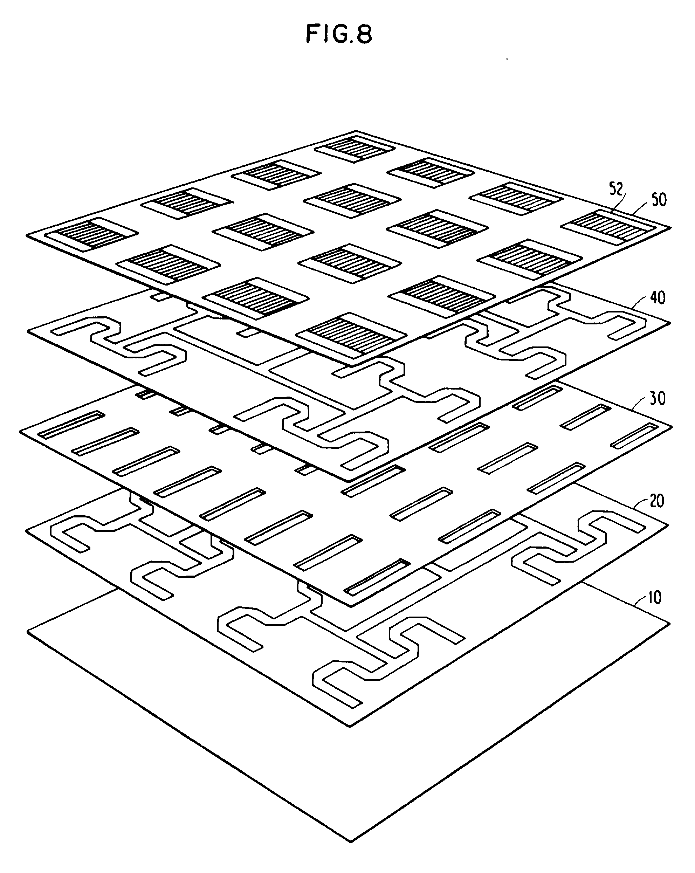

The just-described structure may be implemented as shown in Figure 8 in the lower element array 30. The gridding enables the element array 30 to appear more like a ground plane for the upper array, which operates in an orthogonal polarization, depending on the orientation of the feedline (e.g. 22, shown in outline) with respect to the grid structure of the radiating element (e.g. 32).

Figure 5b shows an orthogonal feedline configuration which differs from Figure 5a in that the radiating element 52 has an interior metal region 52b with additional metal removed, so that thin strips 52b′ are left. These strips are separated by spaces 52a′ where metallization has been removed. When used in a dual polarized array, the element in Figure 5b is gridded in a direction orthogonal to the polarization of the second array and hence, is essentially transparent to this polarization. For example, Figure 5b contains gridded elements that are orthogonal to the radiation associated with Figure 6a.

Similarly, Figure 6b shows an ungridded element 54 with interior metallization region 54a and continuous surrounding slot 54b, and Figure 5c shows a corresponding gridded element with remaining metal strips 54a′ and intervening spaces 54b′, again with the feedline parallel to the grid as in Figure 5b. If such an element is used in the top layer 50 of radiating elements shown in Figure 8, the element will radiate at a polarization perpendicular to that of layer 30, with the orthogonally polarized radiation of layer 30 propagating through without being attenuated.

Figure 5d shows another example of grid structure which is essentially a gridded version of Figure 5a. Such structure yields an element 56 with central metallization portions 56b and outer metallization portions 56b′ within the slot regions. The gridded portions appear electrically continuous to a polarized signal parallel to the grids, and transparent to signals orthogonal to the grid.

In the foregoing embodiments, the strip width and spacing should be a small fraction of a wavelength of received radiation.

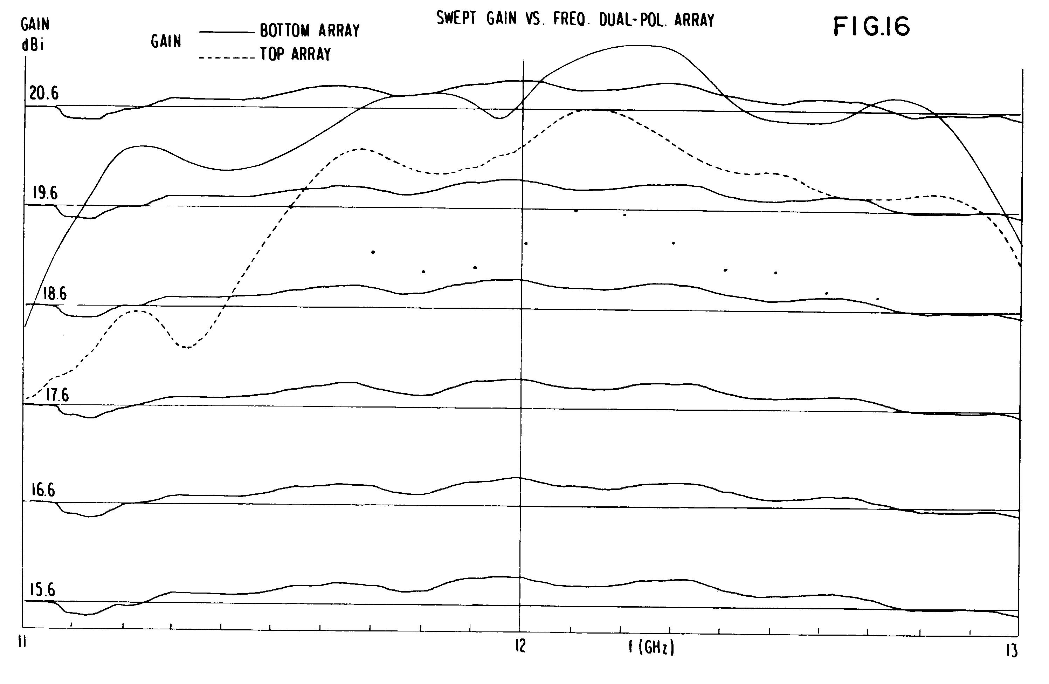

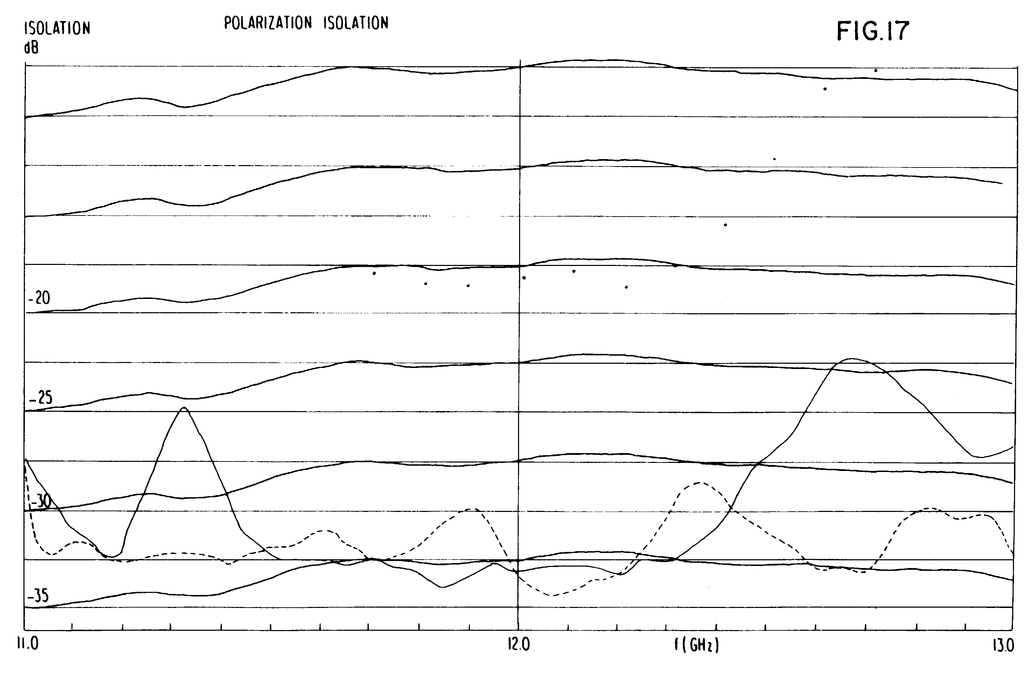

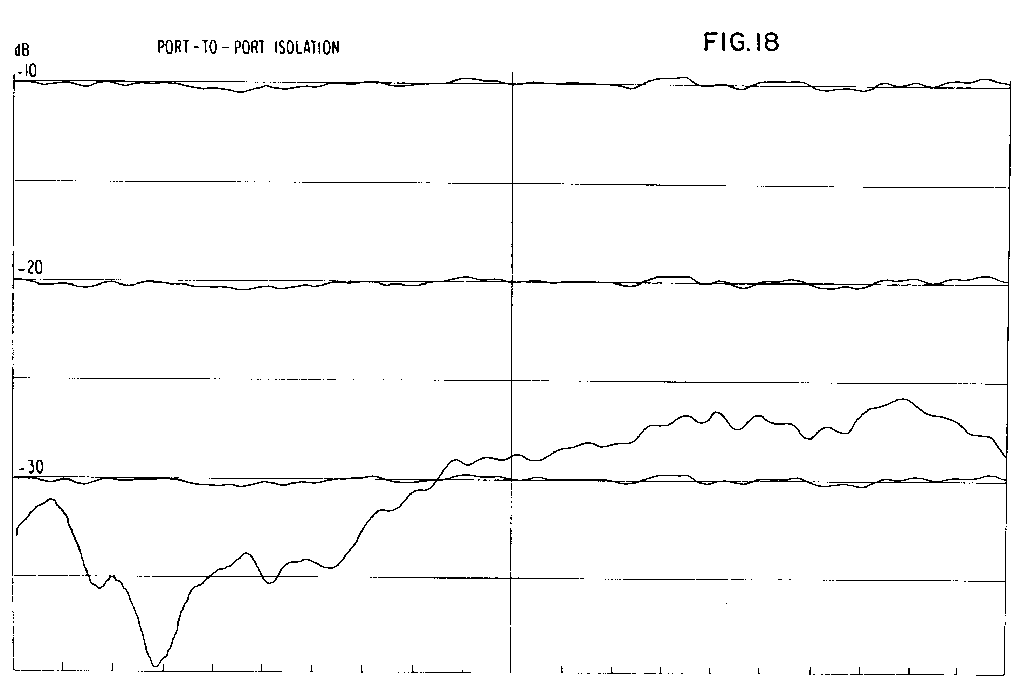

Pursuant to the foregoing description, the structure of the dual-polarized structure yields orthogonally polarized radiating element arrays 30, 50 which are completely isolated from each other, with each array performing in the same manner whether operated along or in the dual-polarization environment. This is so despite the fact that the two arrays use the same overall projected aperture area. Figures 16 to 18 show the superior gain, polarization isolation, and port-to-port isolation achieved in a 16-element array using the Figure 8 structure.

As described above, for a dual-polarization configuration, it is desirable to have the radiating elements of one array be of a slightly different shape from the other array, in order to provide superior isolation of the arrays. However, with the grids in the respective arrays being mutually orthogonal according to the present invention, the shapes may be similar, and either regular (as shown in Figure 5c) or non-regular (as shown in Figures 5a and 5b), so that when placed perpendicular to each other, superior gain and isolation characteristics may be achieved.

The elements shown in Figures 5a-5d may be connected to the power dividers at a single feedpoint, as described in U.S. Patent No. 4,761,654 and Application Ser.No. 930,187 for a linearly polarized array. By connecting a quadrature hybrid (Fig. 9) at the input, the array may be operated so as to achieve dual circular polarization.

Also, while Figures 5a to 5d show generally rectangular-or square-shaped elements, the techniques described may be applicable to elements of any arbitrary but predefined shape, such as a circular element or a rhomboid element.

## Claims

1. A dual-polarized printed antenna comprising:
a ground plane (100);
a first power divider array (200) disposed over said ground plane;
a second power divider array (400) disposed over said first power divider array;
a first array of radiating elements (500) disposed over said second power divider array;
a second array of radiating elements (300) disposed between said first and second power divider arrays (200, 400), said first power divider array (200) and said second array of radiating elements (300) being capacitively coupled to each other, and said second power divider array (400) and said first array of radiating elements (500) being capacitively coupled to each other;
**characterized in** that said first and second arrays of radiating elements (500, 300) comprise radiating patches or radiating slots, said radiating patches or radiating slots having tabs (18b) or notches (18a) added thereto so as to achieve circular polarization.

2. An antenna as claimed in claim 1, wherein each of said radiating elements in said first array of radiating elements comprises first, second, and third regions, at least one of said first through third regions comprising a gridded metallization region (32c, 52b).

3. An antenna as claimed in claim 2, further **characterized in** that each of said radiating elements in said second array of radiating elements comprises fourth, fifth and sixth regions, at least one of said fourth through sixth regions comprising a gridded metallization region (32c, 52b).

4. An antenna as claimed in claim 1, further **characterized in** that each of said radiating elements in said second array of radiating elements comprises a slot configuration in which a metal portion (32b) has slots (32c) on either side thereof, said slots being formed by removing portions of said metallization layer to form a gridded metallization region wherein metal is selectively removed and a plurality of parallel metal strips (32b') remain, said strips being separated at regular intervals by absences (32a') of said metal.

5. An antenna as claimed in claim 2 or claim 3, wherein said first and third regions and/or said fourth and sixth regions have metallization completely removed therefrom to form slots, and said second region and/or said fifth region comprises said gridded metallization region.

6. An antenna as claimed in claim 2 or claim 3, wherein said first and third regions and/or said fourth and sixth regions have metallization selectively removed therefrom to form additional gridded metallization regions.

7. An antenna as claimed in claim 6, wherein said second region and/or said fifth region has no metal removed therefrom.

8. An antenna as claimed in claim 1, wherein said first power divider array feeds each of said radiating elements in said second array of radiating elements at a single feedpoint, and wherein said second power divider array feeds each of said radiating elements in said first array of radiating elements at a single feedpoint.

9. An antenna as claimed in claim 2 or claim 3, wherein said first and third regions and/or said fourth and sixth regions have metallization completely removed therefrom to form slots, said second region and/or said fifth region comprising said gridded metallization region, and wherein said second array of radiating elements is disposed with respect to said first array of radiating elements such that said first and second power divider arrays feed respective ones of said second and fifth regions in mutually orthogonal fashion.

10. An antenna according to claim 1, further **characterized in** that each of the radiating elements in said first array of radiating elements comprises slots, and each of the elements in said second array of radiating elements comprises slots with sufficient metallization added to divide each element within said second array of radiating elements into two U-shaped portions (16a), said metallization optionally being sufficient to divide each element within said second array of radiating elements into two parallel rectangular portions.

11. An antenna as claimed in claim 1, further comprising a quadrature hybrid (250) connected to respective inputs of said antenna, so as to achieve two independent senses of circular polarization.

12. An antenna as claimed in claim 1, wherein said second power divider array has its elements disposed at a different angular orientation than the elements of said first power divider array.

13. An antenna as claimed in claim 1, wherein said second power divider array has its elements disposed orthogonally with respect to elements of said first power divider array, such that senses of polarization achieved by said antenna are mutually orthogonal.

14. An antenna as claimed in claim 1, wherein all of said patches or slots are square-shaped or circular in shape.

15. An antenna as claimed in claim 1, wherein all of said ground plane, said first and second power divider arrays, and said first and second arrays of radiating elements are mutually separated by a suitable dielectric selected from the group consisting of air, polyethylene, Duroid (tm) , nomex, and Teflon (tm).

16. An antenna as claimed in claim 10, wherein said metallization is added where portions of said second power divider array pass underneath corresponding elements in said first array of radiating elements, so as to minimize cross-talk.

17. An antenna as claimed in claim 1, wherein said second array of radiating elements and said first power divider array, together with said ground plane, form a first antenna array having a first sense of polarization, and wherein said first array of radiating elements and said second power divider array, together with said second array of radiating elements, form a second antenna array having a second sense of polarization orthogonally to said first sense of polarization.

## Patentansprüche

1. Zweifachpolarisierte gedruckte Antenne, die folgendes aufweist:
eine Groundplane (100);
eine erste Leistungsteilergruppe (200), die über der Groundplane angeordnet ist;
eine zweite Leistungsteilergruppe (400), die über der ersten Leistungsteilergruppe angeordnet ist;
eine erste Gruppe von Strahlerelementen (500), die über der zweiten Leistungsteilergruppe angeordnet ist;
eine zweite Gruppe von Strahlerelementen (300), die zwischen der ersten und der zweiten Leistungsteilergruppe (200, 400) angeordnet ist, wobei die erste Leistungsteilergruppe (200) und die zweite Gruppe von Strahlerelementen (300) miteinander kapazitiv gekoppelt sind und wobei die zweite Leistungsteilergruppe (400) und die erste Gruppe von Strahlerelementen (500) miteinander kapazitiv gekoppelt sind;
**dadurch gekennzeichnet,** daß die erste und die zweite Gruppe von Strahlerelementen (500, 300) Strahlerpads oder Strahlerschlitze aufweist, wobei die Strahlerpads oder Strahlerschlitze hinzugefügte Nasen (18b) oder Ausschnitte (18a) haben, um eine Zirkularpolarisation zu erreichen.

2. Antenne nach Anspruch 1, wobei jedes der Strahlerelemente in der ersten Gruppe von Strahlerelementen einen ersten, zweiten und dritten Bereich aufweist, wobei wenigstens einer von dem ersten bis dritten Bereich einen gitterförmigen Metallisierungsbereich (32c, 52b) aufweist.

3. Antenne nach Anspruch 2, ferner dadurch gekennzeichnet, daß jedes der Strahlerelemente in der zweiten Gruppe von Strahlerelementen einen vierten, fünften und sechsten Bereich aufweist, wobei wenigstens einer von dem vierten bis sechsten Bereich einen gitterförmigen Metallisierungsberiech (32c, 52b) aufweist.

4. Antenne nach Anspruch 1, ferner dadurch gekennzeichnet, daß jedes der Strahlerelemente in der zweiten Gruppe von Strahlerelementen eine Schlitzkonfiguration aufweist, wobei ein Metallbereich (32b) Schlitze (32c) auf beiden Seiten davon hat und die Schlitze durch Entfernen von Bereichen der Metallisierungsschicht gebildet sind, um einen gitterförmigen Metallisierungsbereich zu bilden, wobei Metall selektiv entfernt ist und eine Vielzahl von parallelen Metallstreifen (32b') zurückbleibt, wobei die Streifen in regelmäßigen Abständen durch Abwesenheiten (32a') des Metalls voneinander getrennt sind.

5. Antenne nach Anspruch 2 oder 3, wobei von dem ersten und dem dritten Bereich und/oder dem vierten und dem sechsten Bereich die Metallisierung vollständig entfernt ist, um Schlitze zu bilden, und wobei der zweite Bereich und/oder der fünfte Bereich den gitterförmigen Metallisierungsbereich aufweist.

6. Antenne nach Anspruch 2 oder Anspruch 3, wobei von dem ersten und dem dritten Bereich und/oder dem vierten und dem sechsten Bereich Metallisierung selektiv entfernt ist, um zusätzliche gitterförmige Metallisierungsbereiche zu bilden.

7. Antenne nach Anspruch 6, wobei von dem zweiten Bereich und/oder dem fünften Bereich kein Metall entfernt ist.

8. Antenne nach Anspruch 1, wobei die erste Leistungsteilergruppe jedes Strahlerelement in der zweiten Gruppe von Strahlerelementen an einem einzigen Einspeisungspunkt speist und wobei die zweite Leistungsteilergruppe jedes Strahlerelement in der ersten Gruppe von Strahlerelementen an einem einzigen Einspeisungspunkt speist.

9. Antenne nach Anspruch 2 oder Anspruch 3, wobei von dem ersten und dem dritten Bereich und/oder dem vierten und dem sechsten Bereich die Metallisierung vollständig entfernt ist, um Schlitze zu bilden, wobei der zweite Bereich und/ oder der fünfte Bereich den gitterförmigen Metallisierungsbereich aufweisen, und wobei die zweite Gruppe von Strahlerelementen in bezug auf die erste Gruppe von Strahlerelementen so angeordnet ist, daß die erste und die zweite Leistungsteilergruppe jeweils den zweiten bzw. den fünften Bereich in zueinander orthogonaler Weise speisen.

10. Antenne nach Anspruch 1, ferner dadurch gekennzeichnet, daß jedes Strahlerelement in der ersten Gruppe von Strahlerelementen Schlitze aufweist, und jedes Element in der zweiten Gruppe von Strahlerelementen Schlitze mit ausreichender zugefügter Metallisierung aufweist, um jedes Element in der zweiten Gruppe von Strahlerelementen in zwei U-förmige Bereiche (16a) zu teilen, wobei die Metallisierung fakultativ ausreichend ist, um jedes Element innerhalb der zweiten Gruppe von Strahlerelementen in zwei parallele rechteckige Bereiche zu teilen.

11. Antenne nach Anspruch 1, die ferner eine Quadraturverzweigung (250) aufweist, die mit jeweiligen Eingängen der Antenne verbunden ist, um so zwei unabhängige Zirkularpolarisationsrichtungen zu erhalten.

12. Antenne nach Anspruch 1, wobei die Elemente der zweiten Leistungsteilergruppe in einer anderen Winkelorientierung als die Elemente der ersten Leistungsteilergruppe angeordnet sind.

13. Antenne nach Anspruch 1, wobei die Elemente der zweiten Leistungsteilergruppe in bezug auf Elemente der ersten Leistungsteilergruppe orthogonal angeordnet sind, so daß die von der Antenne erzielten Polarisationsrichtungen zueinander orthogonal sind.

14. Antenne nach Anspruch 1, wobei sämtliche Pads oder Schlitze quadratische oder kreisrunde Gestalt haben.

15. Antenne nach Anspruch 1, wobei die Groundplane, die erste und die zweite Leistungsteilergruppe sowie die erste und die zweite Gruppe von Strahlerelementen sämtlich jeweils durch ein geeignetes Dielektrikum voneinander getrennt sind, das aus der Gruppe ausgewählt ist, die aus Luft, Polyethylen, Duroid (Wz), Nomex und Teflon (Wz) besteht.

16. Antenne nach Anspruch 10, wobei die Metallisierung dort angebracht ist, wo Bereiche der zweiten Leistungsteilergruppe unter entsprechenden Elementen in der ersten Gruppe von Strahlerelementen durchlaufen, um so Übersprechen zu minimieren.

17. Antenne nach Anspruch 1, wobei die zweite Gruppe von Strahlerelementen und die erste Leistungsteilergruppe gemeinsam mit der Groundplane eine erste Antennengruppe bilden, die eine erste Polarisationsrichtung hat, und wobei die erste Gruppe von Strahlerelementen und die zweite Leistungsteilergruppe gemeinsam mit der zweiten Gruppe von Strahlerelementen eine zweite Antennengruppe bilden, die eine zu der ersten Polarisationsrichtung orthogonale zweite Polarisationsrichtung hat.

## Revendications

1. Antenne imprimée à double polarisation comprenant :
un plan de base (100) ;
un premier réseau diviseur de puissance (200) disposé au-dessus dudit plan de base ;
un second réseau diviseur de puissance (400) disposé au-dessus dudit premier réseau diviseur de puissance ;
un premier réseau d'éléments radiants (500) disposé au-dessus dudit second réseau diviseur de puissance ;
un second réseau d'éléments radiants (300) disposé entre lesdits premier et second réseaux diviseurs de puissance (200, 400), ledit premier réseau diviseur de puissance (200) et ledit second réseau d'éléments radiants (300) étant couplés capacitivement l'un à l'autre, et ledit second réseau diviseur de puissance (400) et ledit premier réseau d'éléments radiants (500) étant couplés capacitivement l'un à l'autre,
caractérisée en ce que lesdits premier et second réseaux d'éléments radiants (500, 300) comprennent des pastilles radiantes ou des fentes radiantes, lesdites pastilles radiantes ou fentes radiantes ayant des pattes (18b) ou des encoches (18a) rajoutées à elles de manière à réaliser une polarisation circulaire.

2. Antenne selon la revendication 1, dans laquelle chacun desdits éléments radiants dans ledit premier réseau d'éléments radiants comprend des première, deuxième et troisième régions, au moins une parmi lesdites première à troisième régions comprenant une région de métallisation en grille (32c, 52b).

3. Antenne selon la revendication 2, caractérisée en outre en ce que chacun desdits éléments radiants dans ledit second réseau d'éléments radiants comprend des quatrième, cinquième et sixième régions, au moins une parmi lesdites quatrième à sixième régions comprenant une région de métallisation en grille (32c, 52b).

4. Antenne selon la revendication 1, caractérisée en outre en ce que chacun desdits éléments radiants dans ledit second réseau d'éléments radiants comprend une configuration de fentes dans laquelle une portion de métal (32b) a des fentes (32c) sur chacune de ses faces, lesdites fentes étant formées en retirant des portions de ladite couche de métallisation pour former une région de métallisation en grille dans laquelle du métal est sélectivement retiré et une pluralité de bandes de métal parallèles (32b') restantes, lesdites bandes étant séparées à intervalles réguliers par des absences (32a') dudit métal.

5. Antenne selon la revendication 2 ou 3, dans laquelle la métallisation desdites première et troisième régions et/ou desdites quatrième et sixième régions a été complètement retirée pour former des fentes, et ladite deuxième région et/ou ladite cinquième région comprend ladite région de métallisation en grille.

6. Antenne selon la revendication 2 ou 3, dans laquelle la métallisation desdites première et troisième régions et/ou desdites quatrième et sixième régions a été sélectivement retirée pour former des régions de métallisation en grille additionnelles.

7. Antenne selon la revendication 6, dans laquelle il n'y a pas de métal retiré de ladite deuxième région et/ou de ladite cinquième région.

8. Antenne selon la revendication 1, dans laquelle ledit premier réseau diviseur de puissance alimente chacun desdits éléments radiants dans ledit second réseau d'éléments radiants en un seul point d'alimentation et dans laquelle ledit second réseau diviseur de puissance alimente chacun desdits éléments radiants dans ledit second réseau d'éléments radiants en un seul point d'alimentation.

9. Antenne selon la revendication 2 ou 3, dans laquelle la métallisation desdites première et troisième régions et/ou desdites quatrième et sixième régions a été complètement retirée pour former des fentes, ladite deuxième région et/ou ladite cinquième région comprenant ladite région de métallisation en grille, et dans laquelle ledit second réseau d'éléments radiants est disposé par rapport audit premier réseau d'éléments radiants de telle sorte que lesdits premier et second réseaux diviseurs de puissance alimentent respectivement une desdites deuxième et cinquième régions dans un mode mutuellement orthogonal.

10. Antenne selon la revendication 1, caractérisée en outre en ce que chacun des éléments radiants dans ledit premier réseau d'éléments radiants comprend des fentes, et chacun des éléments dans ledit second réseau d'éléments radiants comprend des fentes avec une métallisation suffisante ajoutée pour diviser chaque élément dans ledit second réseau d'éléments radiants en deux portions en forme de U (16a), ladite métallisation étant optionnellement suffisante pour diviser chaque élément dans ledit second réseau d'éléments radiants en deux portions rectangulaires parallèles.

11. Antenne selon la revendication 1, comprenant en outre un hybride de quadrature (250) connecté aux entrées respectives de ladite antenne, de manière à réaliser deux sens indépendants de polarisation circulaire.

12. Antenne selon la revendication 1, dans laquelle ledit second réseau diviseur de puissance a ses éléments disposés avec une orientation angulaire différente à celle des éléments dudit premier réseau diviseur de puissance.

13. Antenne selon la revendication 1, dans laquelle ledit second réseau diviseur de puissance a ses éléments disposés perpendiculairement par rapport aux éléments dudit premier réseau diviseur de puissance, de sorte que les sens de polarisation réalisés par ladite antenne sont mutuellement perpendiculaires.

14. Antenne selon la revendication 1, dans laquelle l'ensemble desdites pastilles ou fentes sont rectangulaires ou circulaires en forme.

15. Antenne selon la revendication 1, dans laquelle l'ensemble desdits plans de base, desdits premier et second réseaux diviseurs de puissance, et desdits premier et second réseaux d'éléments radiants sont mutuellement séparés par un diélectrique approprié choisi dans le groupe constitué de l'air, du polyéthylène, du Duroid (marque déposée), du nomex et du Teflon (marque déposée).

16. Antenne selon la revendication 10, dans laquelle ladite métallisation est ajoutée là où des portions dudit second réseau diviseur de puissance passe en-dessous d'éléments correspondants dans ledit premier réseau d'éléments radiants, de manière à minimaliser la diaphonie.

17. Antenne selon la revendication 1, dans laquelle ledit second réseau d'éléments radiants et ledit premier réseau diviseur de puissance, ensemble avec ledit plan de base, forment un premier réseau d'antenne ayant un premier sens de polarisation, et dans laquelle ledit premier réseau d'éléments radiants et ledit second réseau diviseur de puissance, ensemble avec ledit second réseau d'éléments radiants, forment un second réseau d'antenne ayant un second sens de polarisation perpendiculaire audit premier sens de polarisation.
